Europäisches Patentamt

European Patent Office

Office européen des brevets

(19)

(11) Veröffentlichungsnummer: **0 157 938**
**A2**

## (12) EUROPÄISCHE PATENTANMELDUNG

(21) Anmeldenummer: 84115595.5

(22) Anmeldetag: 17.12.84

(51) Int. Cl.⁴: **H 05 K 5/06**
**H 01 L 23/04**

(30) Priorität: 23.03.84 DE 3410787

(43) Veröffentlichungstag der Anmeldung
16.10.85 Patentblatt 85/42

(84) Benannte Vertragsstaaten:
BE DE FR GB IT NL

(71) Anmelder Siemens Aktiengesellschaft
Berlin und Munchen Wittelsbacherplatz 2
D-8000 München 2(DE)

(72) Erfinder: Schmotz, Ernst, Ing.grad.
Mühlbachring 5
D-8202 Willing(DE)

(72) Erfinder: Stelzl, Hans, Ing.
Rotkehlchenweg 4
D-8011 Vaterstetten(DE)

(54) Gehäuse für elektrische Bauelemente.

(57) Gehause für elektrische Bauelemente, Bauelemente-gruppen oder integrierte Schaltungen, insbesondere für elektrische Oberflächenwellenfilter, bei denen der elektrisch aktive Teil (3) auf einen Träger (1) aufgebracht ist der durch das Gehause nach außen geführte Anschlußteile (15, 17 bis 20) für die mechanische und elektrische Verbindung mit einer gedruckten Schaltung aufweist, wobei eine Wanne (5) aus duroplastischem Werkstoff gegen die Unterseite des Tragers (1) anliegt und mit ihrer Seitenwandung (6) auf den Randflachen (8) der Trägeroberseite aufsitzt, über der Wanne (5) ein wannenförmiger Deckel (7, 7a) aus duroplastischem Werkstoff angeordnet ist, derart, daß der aktive Teil (3) in einem Hohlraum (4) liegt, und die Wanne (5) samt Deckel (7, 7a) mit duroplastischem Werkstoff (9) umhüllt ist.

FIG 2

EP 0 157 938 A2

Croydon Printing Company Ltd

Siemens Aktiengesellschaft
Berlin und München

Unser Zeichen
VPA 84 P 1 2 4 0 E

Gehäuse für elektrische Bauelemente, Bauelementegruppen
oder integrierte Schaltungen

Die Erfindung betrifft ein Gehäuse für elektrische Bauelemente, Bauelementegruppen oder integrierte Schaltungen,
insbesondere für elektrische Oberflächenwellen-Filter, bei
denen der elektrisch aktive Teil auf einen Träger aufgebracht ist, der durch das Gehäuse nach außen geführte Anschlußteile für die mechanische und elektrische Verbindung
mit einer gedruckten Schaltung aufweist.

Die DE-OS 30 11 730 schlägt zur Schaffung hermetisch abgedichteter Gehäuse bereits vor, daß diese aus einem rechteckigen Schalenteil und einem darin eingepaßten Deckelteil
bestehen und mittels Kunstharzverguß hermetisch dicht verschlossen sind. Der Schalenteil weist dabei in seinen
einander gegenüberliegenden Seitenwänden Ausnehmungen auf,
die den rechtwinklig abgebogenen Anschlußteilen des elektrischen Bauelementes angepaßt sind, und besitzt darüberhinaus einen abgesetzten Teil, der zusammen mit einem Steg,
der auf dem Deckelteil nach außen gerichtet vorhanden ist,
eine umlaufende Rinne bildet, die mit der Vergußharzabdichtung gefüllt ist.

Die DE-OS 32 32 887 beschreibt ein elektrisches Bauelement
und zwar insbesondere ein elektrisches Oberflächenwellenfilter sowie ein Verfahren zu seiner Herstellung, bei dem
der aktive Teil des elektrischen Bauelements auf einem
Metallträger befestigt und zusammen mit Anschlußfahnen in
einem Kunststoffgehäuse aus elektrisch leitfähigem Material

Kra 1 Gae / 20.03.84

untergebracht ist. Wenigstens eine der Anschlußfahnen ist dabei mit dem Kunststoffgehäuse mittels eines elektrisch leitfähigen Klebers galvanisch verbunden. Bei der Herstellung dieses Bauelements wird der Metallträger so geformt, daß die notwendige Masseanschlußfahne entsteht und diese beim Zusammenbau möglichst an oder nahe der Innenoberfläche des Kunststoffgehäuses liegt und dadurch eine Verbindung durch Kleben ermöglicht.

Alle diese elektrischen Bauelemente, Bauelementegruppen und integrierte Schaltungen sind auf Träger aufgebracht, die üblicherweise aus Metallblech bestehen und bereits die durch das Gehäuse geführten äußeren Anschlußteile für die mechanische und elektrische Verbindung mit einer gedruckten Schaltung besitzen. Beim Zusammenbau werden die äußeren Anschlußteile entweder in einer Ebene mit dem Träger belassen oder rechtwinklig abgebogen. Soweit es sich dabei um integrierte Schaltungen und Halbleiterbauelemente handelt, werden diese üblicherweise in Spritzformen mit einer Umhüllung versehen. Gelegentlich muß das elektrische Bauelement oder die integrierte Schaltung in einem Hohlraum des Gehäuses untergebracht sein, der ggf. sogar mit Inertgas gefüllt ist.

Der vorliegenden Erfindung liegt die Aufgabe zugrunde, ein Gehäuse der vorstehend genannten Art zu schaffen, das insbesondere zum Schutz elektrischer Oberflächenwellenfilter-Chips, geeignet ist. Dieses Gehäuse soll einen über dem Oberflächenwellenfilter-Chip angeordneten, gegen Feuchtigkeit hermetisch abgeschirmten Hohlraum aufweisen, wobei die aus dem Hohlraum herausgeführten Anschlußteile mühelos in eine geätzte Leiterplatte einlötbar bzw. auf diese flach auflötbar sein sollen.

Zur Lösung dieser Aufgabe sieht die Erfindung bei einem Gehäuse gemäß Oberbegriff des Patentanspruchs 1 vor, daß eine Wanne aus duroplastischem Werkstoff gegen die Unterseite des Trägers anliegt und mit ihrer Seitenwandung auf den Randflächen der Trägeroberseite aufsitzt, daß über der Wanne ein wannenförmiger Deckel aus duroplastischem Werkstoff angeordnet, z.B. ein wannenförmiger Deckel über die Wanne gestülpt oder in diese eingesetzt ist, derart, daß der aktive Teil, z.B. Oberflächenwellenfilter-Chip, in einem Hohlraum liegt, und daß die Wanne samt Deckel mit duroplastischem Werkstoff umhüllt ist.

Die Wanne, der Deckel und die Umhüllung für die Wanne und den Deckel sind dabei bevorzugt in getrennten Spritzpreßverfahren hergestellt, wodurch eine erhebliche Fertigungsvereinfachung erzielt wird.
Der verwendete duroplastische Werkstoff gewährleistet eine hohe Temperaturfestigkeit, die insbesondere beim Tauchlöten; d.h. beim Einlöten der elektrischen Anschlußteile in gedruckte Schaltungsplatten erforderlich ist. Die hermetisch dichte Abschirmung des Hohlraums gegen Feuchtigkeit ist vor allem auch auf die Tatsache zurückzuführen, daß duroplastischer Werkstoff an Metallteilen gut abdichtet.

Die Erfindung wird nachstehend anhand von Figuren näher erläutert. Es zeigt:

Fig. 1 in vergrößertem Maßstab eine Draufsicht auf ein Oberflächenwellenfilter nach der Erfindung, bei dem der Deckel und die Umhüllung weggelassen sind,
Fig. 2 einen Schnitt gemäß der Linie 2-2' nach Fig. 1, jedoch mit Deckel und Umhüllung,

Fig. 3 in der Darstellung nach Fig. 2 ein weiteres Ausführungsbeispiel des Gegenstandes nach der Erfindung.

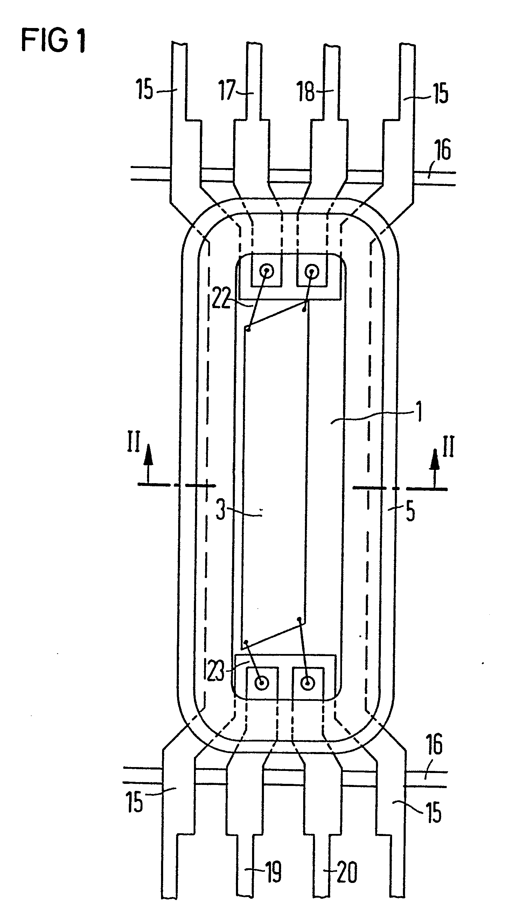

In Fig. 1 ist mit 1 der z.B. aus Cu-Fe-Blech ausgestanzte
Träger für einen auf diesen Träger aufgeklebten Oberflächenwellenfilter-Chip 3 bezeichnet. Die in der Fig. zur
Vereinfachung nicht dargestellten Eingangs= und Ausgangswandler des Oberflächenwellenfilters liegen über Bonddrahtkontaktierungen 22 bzw. 23 an Anschlußbeinen 17, 18 bzw. 19,
20, die gleichfalls aus dem Trägerblech ausgestanzt sind.
Mit 15 sind symmetrisch zu diesen Anschlußbeinen ausgerichtete Massebeine bezeichnet, die an den Träger 1 einstückig angeformt sind und so als Kurzschlußschleifen
wirken, welche durch die in ihnen induzierten Ströme die
durch die Ein- und Ausgangsströme erzeugten Felder und
damit die Verkoppelung von Filterein= und Ausgang verringern.

Bei der Herstellung des Gehäuses wird zunächst der samt
seinen Anschluß= und Massebeinen aus Blech ausgestanzte
Träger 1 mittels seiner Anschlußbeine 15 auf stegartige
Haltevorrichtungen 16 aufgelegt. Die Haltevorrichtungen 16
sind dabei so ausgebildet, daß die vereinzelten Anschlußbeine 17 bis 20 räumlich isoliert zu den Massebeinen 15
ausgerichtet sind.

In einem ersten Spritzpreßverfahren wird zunächst eine
Wanne 5 aus duroplastischem Werkstoff gefertigt, die gegen
die Unterseite des Trägers 1 anliegt und mit ihrer Seitenwandung 6 auf den Randflächen 8 der Trägeroberseite aufsitzt. Auf ihrer Unterseite ist dabei die Wanne 5 mit nach
außen gekehrten Noppen 12 ausgestattet.

Ein wanneförmiger Deckel 7 aus duroplastischem Werkstoff, der vorteilhafterweise gleichfalls in einem Spritzpreßverfahren hergestellt ist und Noppen 10, 11 aufweist, ist über die Wanne 5 gestülpt. Der Deckel 7 liegt dabei mittels seiner Noppen 10 auf der Seitenwand-Stirnfläche 13 der Wanne 5 auf und bildet zusammen mit der Wanne 5 einen Hohlraum 4, innerhalb dem der Oberflächenwellenfilter-Chip 3 hermetisch dicht angeordnet ist. Anstelle der Noppen 10 kann auch die Seitenwand-Stirnfläche 13 der Wanne 5 mit Noppen zur Auflage des Deckels 7 ausgebildet sein.

In einem letzten Spritzpreßverfahren werden schließlich die Wanne 5 und der Deckel 7 mit weiterem duroplastischem Werkstoff 9 umhüllt und so die vollständige hermetische Abdichtung des Hohlraumes 4 bewirkt. Durch die wanneförmige Gestaltung des Deckels 7 wird i.ü. beim abschließenden Umhüllen der Wanne 5 und des Deckels 7 ein Eindringen von Preßmasse in den Hohlraum 4 verhindert.

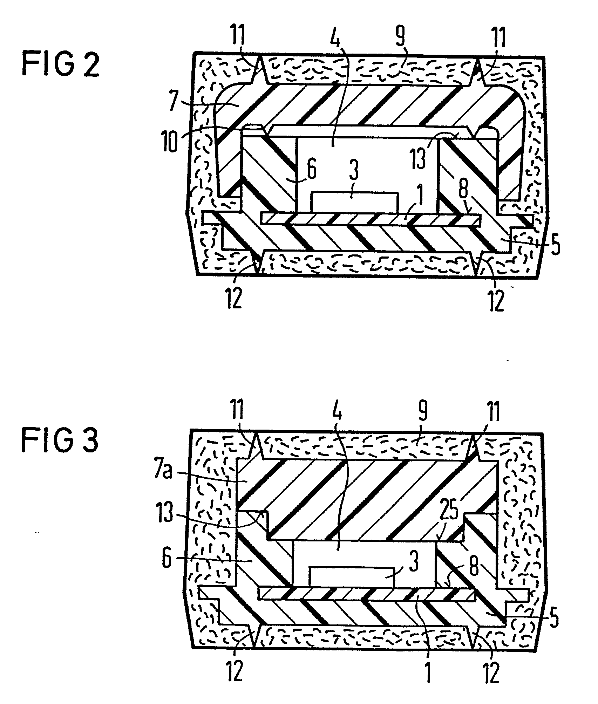

Gemäß Fig. 3 kann der wannenförmige Deckel 7 durch einen Deckel 7 a ersetzt sein, der auf seiner zur Wanne 5 gekehrten Stirnwand 25 stufenförmig abgesetzt ist und in entsprechende Stufen der Wanne 5 eingreift.

Die nach Entfernung der Stege 16 freien Enden der durch die Spritzpreßverfahren im Gehäuse fixierten Masse= und Anschlußbeine können je nach Bedarf abgebogen und in entsprechende Löcher einer gedruckten Leiterplatte eingesteckt oder flach auf entsprechende Leiterbahnen aufgelötet werden.

Patentansprüche

1. Gehäuse für elektrische Bauelemente, Bauelementegruppen oder integrierte Schaltungen, insbesondere für elektrische Oberflächenwellen-Filter bei denen der elektrisch aktive Teil auf einen Träger aufgebracht ist, der durch das Gehäuse nach außen geführte Anschlußteile für die mechanische und elektrische Verbindung mit einer gedruckten Schaltung aufweist, d a d u r c h g e k e n n z e i c h n e t, daß eine Wanne (5) aus duroplastischem Werkstoff gegen die Unterseite des Trägers (1) anliegt und mit ihrer Seitenwandung (6) auf den Randflächen (8) der Trägeroberseite aufsitzt, daß über der Wanne ein wannenförmiger Deckel (7, 7a) aus duroplastischem Werkstoff angeordnet ist, derart, daß der aktive Teil (3) in einem Hohlraum (4) liegt, und daß die Wanne samt Deckel mit duroplastischem Werkstoff (9) umhüllt ist.

2. Gehäuse nach Anspruch 1, d a d u r c h g e k e n n z e i c h n e t, daß der Deckel (7) wannenförmig ist und über die Wanne (5) gestülpt ist.

3. Gehäuse nach Anspruch 1 und 2, d a d u r c h g e k e n n z e i c h n e t, daß der Deckel (7) mittels Noppen (10), die auf seiner zur Seitenwand-Stirnfläche (13) der Wanne (5) gekehrten Bodenfläche angeordnet sind, auf der Wanne aufliegt.

4. Gehäuse nach Anspruch 1 bis 3, d a d u r c h g e k e n n z e i c h n e t, daß die Seitenwand-Stirnfläche (13) der Wanne (5) Noppen aufweist, auf denen der Deckel (7) aufliegt.

**0157938**

5. Geäuse nach Anspruch 1, d a d u r c h  g e k e n n -
z e i c h n e t,  daß die Wanne (5) und der Deckel (7a) auf
ihren einander zugekehrten Stirnflächen (13, 25) stufenförmig abgesetzt sind, derart, daß die Stufen ineinandergreifen.

6. Gehäuse nach Anspruch 1 und 5, d a d u r c h  g e -
k e n n z e i c h n e t,  daß die Wanne (5), der Deckel (7)
und die Umhüllung (9) für die Wanne und den Deckel im
Spritzpreßverfahren hergestellt sind.

7. Verfahren zur Herstellung eines Gehäuses nach Anspruch 1
und wenigstens einem der Ansprüche 2 bis 6, d a d u r c h
g e k e n n z e i c h n e t,  daß der Träger (1) mit seinen
Anschlußteilen (15, 17 bis 20) aus Blech ausgestanzt wird,
und daß der Träger und die Anschlußteile bis zur Fertigstellung der Wanne (5) mittels Haltevorrichtungen (16) in
ihrer teils gegeneinander elektrisch isolierten Stellung
gehalten werden.

0157938

FIG 1

FIG 2

FIG 3